# EUROPEAN PATENT APPLICATION

(11) **EP 1 496 135 A1**
(43) Date of publication of application: **12.01.2005**
(21) Application number: 03715704.7
(22) Date of filing: 01.04.2003
(51) Int. Cl.: C23C 14/34, G11B 7/26

(54) **SPATTERING DEVICE, METHOD OF FORMING THIN FILM BY SPATTERING, AND METHOD OF MANUFACTURING DISK-LIKE RECORDING MEDIUM USING THE DEVICE**

(30) Priority: 04.04.2002 JP 2002102038
(71) Applicant: TDK Corporation, Chuo-ku, Tokyo 103-8272 (JP)
(72) Inventor: KOSHIKAWA, Masato, c/o TDK Corporation, Tokyo 103-8272 (JP); ISHIZAKI, Hideki, c/o TDK Corporation, Tokyo 103-8272 (JP); WATANABE, Hideaki, c/o TDK Corporation, Tokyo 103-8272 (JP); MATSUI, Satoshi, c/o TDK Corporation, Tokyo 103-8272 (JP)
(74) Representative: Grünecker, August, Dipl.-Ing.
(86) International application number: PCT/JP2003/004170
(87) International publication number: WO 2003/085158

(57) **Abstract**

In a sputtering apparatus, an inner mask covering the central portion of a substrate is supported by a bearing provided on a backing plate on the back surface of a target, and further this inner mask abuts against the substrate with a predetermined load by a spring. By this construction, when the depositing of thin film is effected, it becomes possible for the inner mask abutting against the substrate to be rotated together with the substrate, and the non-film formed area of the central portion of the substrate is reliably formed and also, an improvement in film thickness, etc. in a film formed area is achieved.

## Description

### TECHNICAL FIELD

This invention relates to a thin film forming apparatus for and a thin film forming method of forming thin film on a disk-shaped of forming thin film on a disk-shaped substrate. More particularly, this invention also relates to a sputtering apparatus for forming this film by a sputtering method and a so-called inner mask for use in such apparatus, and a disk-shaped recording medium manufacturing method of manufacturing a disk-shaped recording medium such as an optical disk by the use of such apparatus.

### BACKGROUND ART

As recording media manufactured with various kinds of thin film formed on disk-shaped substrates, and particularly recording media having a disk-kike shape, there are various disks including, for example, CD type disks such as CD, CD-R and CD-RW, or optical disks like DVD type disks such as DVD-ROM and DVD-R, or magneto-optical disks such as MO and MD.

These disks are manufactured by laminating thin film on a substrate comprising, for example, a material such as polycarbonate by the use of one of various methods such as a sputtering method and a spin coat method. Generally, the substrate is formed with a through-hole centrally thereof for use for the handling of the substrate when the disk is actually carried on a drive.

Of the laminated thin film, for example, metal thin film used as reflecting film is formed by the use of the sputtering method. In this method, a disk-shaped substrate is fixed and held in opposed relationship with the front of a target in a vacuum chamber brought into predetermined pressure by a gas for discharge such as argon. Generally, in this state, a certain voltage is given to the target, whereby discharge occurs between the target and the substrate, and plasma occurs. A target-constituting element in the surface of the target is sputtered by ions in the plasma, and these sputtered particles adhere to the surface of the substrate, whereby film forming is effected.

In an optical disk or the like, it is necessary that a non-film area in which film forming is not done be provided around a central hole portion provided in a substrate and on the outer peripheral portion of the substrate. Therefore, during the film forming by sputtering, the actual film forming process is carried out with the non-film formed area covered with jigs called an inner mask and an outer mask. This non-film formed area has its width determined by a standard, and a predetermined value must be obtained irrespective of the substrate.

Therefore, in a conventional sputtering apparatus, it has been the practice to fix both of the outer mask and the inner mask to the apparatus, and cover the inner and outer peripheries of the substrate with the substrate brought into contact with or proximity to these masks having had their positional relation defined. Regarding the inner mask, however, a construction such as a beam for fixing this mask to the apparatus has been required, and the presence of this construction between the target and the substrate has led to the possibility that the uniformity of the thin film formed may be deteriorated.

As a countermeasure for that, there has been proposed such a sputtering apparatus as disclosed, for example, in Japanese Patent Application Laid-Open No. H7-331434. In this apparatus, an inner mask extends from the central portion of a target positionally corresponding to the center of a substrate toward the central portion of the substrate. That is, a fulcrum for supporting the inner mask is provided so as to extend perpendicularly to the surface of the target and from this surface to the substrate, thereby suppressing the influence of the fulcrum during thin film forming.

As previously described, the width of the non-film formed area is required to assume a predetermined value without becoming uneven for each substrate. At the same time, the profile such as the film thickness of the thin film in a film formed area is required to exhibit a uniform value up to as near as possible to the boundary portion between the non-film formed area and the film formed area. Accordingly, it is preferable that the inner peripheral end portion of the outer mask and the outer peripheral end portion of the inner mask be in close contact with the substrate to thereby minimize the influence upon the other portions than the non-film formed area.

The substrate is generally formed of an elastic material such as polycarbonate and therefore, may not be plastically deformed even if it is urged against the outer mask or the inner mask by a conveying apparatus or the like with a certain degree of load. However, when some layers of thin film are already formed on the substrate, the contact of the outer mask and the inner mask with those layers of thin film may give an injury such as breakage to those layers of thin film. Such a sputtering apparatus as disclosed in Japanese Patent Application Laid-Open No. H7-331434 wherein the inner mask is firmly fixed is considered to be high in the possibility that such an injury as mentioned above may occur.

Further, in this apparatus, when the substrate used is changed, it is required to change the fixed position of the inner mask in conformity with the substrate at any time, but this adjustment is considered to be not easy. Accordingly, it is considered to be difficult to adapt this apparatus to various substrates. Also, when the recording density of an optical disk or the like becomes higher and the wavelength of a laser beam used for reading or the like becomes shorter, it is desired to more improve the distribution of a film thickness or the like in the thin film obtained at present.

### DISCLOSURE OF THE INVENTION

The present invention has been made in view of the above-noted task, and an object thereof is to provide a thin film forming apparatus which enables an inner mask to always contact with the surface of a substrate with a constant and slight load, irrespective of the kind of the substrate or the number of the laminated layers of formed thin film. Also, an object of the present invention is to provide a thin film forming apparatus which can improve the distribution of the film pressure, film nature, etc. of thin film formed on a substrate.

In order to solve the above-noted task, a sputtering apparatus according to the present invention is a sputtering apparatus for effecting film forming on the surface of a substrate having a substantially disk-like shape in a vacuum chamber, the sputtering apparatus having a target comprising a main constituent element of film to be formed, a backing plate for holding the target by the surface thereof, a substrate holder for holding the substrate and rightly opposing the surface of the substrate to the target, and an outer mask and an inner mask covering the outer peripheral position and central portion, respectively, of the substrate, wherein the inner mask communicates with and is supported by a slide shaft extending through a through-hole formed in the target and supported by a bearing disposed on the backing plate for masking rotation and translation possible, and abuts against the central portion of the substrate through the slide shaft with a predetermined load by biasing means disposed on the backing plate.

In the above-described sputtering apparatus, it is preferable that the biasing means comprise a spring disposed at an end portion differing from an end portion of the slide shaft which communicates with the inner mask. Also, it is preferable that the slide shaft have a portion formed of an insulating material in the portion thereof communicating with the inner mask. Also, it is preferable that the biasing means bias the slide shaft through a thrust bearing.

Further, in the above-described sputtering apparatus, it is preferable that the backing plate protrude from the surface of the target and have a containing chamber formed with an aperture having an inner diameter slightly larger than the diameter of the slide shaft at a location rightly opposed to the center of the substrate, and the slide shaft protruding from the aperture toward the substrate, the bearing and the biasing means be contained in the containing chamber.

Also, in order to solve the above-noted task, a thin film forming method according to the present invention is a method of forming thin film on a substrate having a substantially disk-like shape, the method comprising disposing a target formed of a main constituent material of the thin film, fixing the substrate onto a holder rightly opposed to the target and rotatable about a predetermined axis, causing an inner mask connected to a shaft member extending from the back surface of the target to the front surface of the target through a through-hole formed in the target with the predetermined axis as the center to abut against a predetermined area of the central portion of the substrate, causing plasma to occur between the substrate and the target, sputtering the front surface of the target by ions in the plasma, and depositing on the surface of the substrate thin film having the component of the target as a main constituent element, wherein the inner mask abuts against the substrate with a predetermined load, and when the depositing of the thin film is effected, the inner mask is rotated about the predetermined axis together with the substrate.

Also, a disk-shaped recording medium manufacturing method according to the present invention is a disk-shaped recording medium manufacturing method of forming particular film on a disk-shaped recording medium, the method comprising disposing a target formed of a main constituent material of the particular film, fixing a substantially disk-shaped substrate onto a holder rightly opposed to the target and rotatable about a predetermined axis, causing an inner mask connected to a shaft member extending from the back surface of the target to the front surface of the target through a through-hole formed in the target with the predetermined axis as the center to abut against a predetermined area of the central portion of the substrate, causing plasma to occur between the substrate and target, sputtering the front surface of the target by ions in the plasma, and depositing the particular film on the surface of the substrate, wherein the inner mask abuts against the substrate with a predetermined load, and when the depositing of the thin film is effected, the inner mask is rotated about the predetermined axis together with the substrate.

### BRIEF DESCRIPTION OF THE DRAWINGS

Fig. 1 schematically shows the construction of the essential portions of a sputtering apparatus according to a first embodiment of the present invention in a cross section thereof.
Fig. 2 schematically shows the construction of the essential portions of a sputtering apparatus according to a second embodiment of the present invention in a cross section thereof.

### BEST MODE FOR CARRYING OUT THE INVENTION

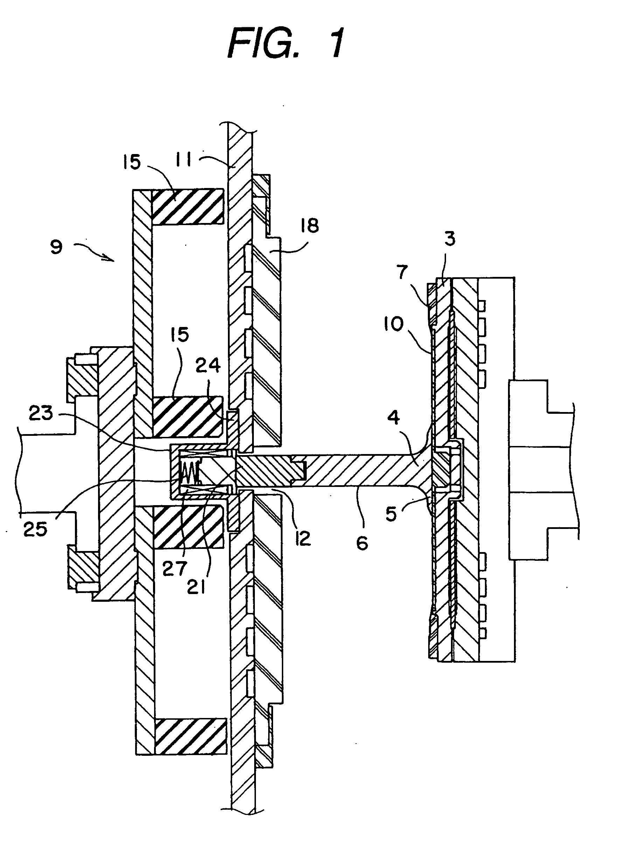

Fig. 1 schematically shows the construction of a cross section of a sputtering apparatus which is a first embodiment of the present invention when a substrate is disposed at a thin film forming position in the apparatus and the apparatus is in a state for effecting film forming. In the present embodiment, description will be made of a magnetron sputtering apparatus in which electron catching probability is enhanced by the effect of a magnetic field formed by a permanent magnet or the like to thereby enhance the rate of sputtering.

In the sputtering apparatus, there are usually disposed various constructions such as a construction called an earth shield used to restrict a discharge space to a particular area near a target, a construction called an adherence preventing shield for preventing the adherence of unnecessary sputter particles to the interior of the apparatus, and a construction used for the conveyance of a substrate. These constructions, however, have no direct relation with the present invention and therefore need not be shown and described herein. Of course, however, these becomes necessary as the actual construction of the apparatus.

As shown in Fig. 1, the sputtering apparatus according to the present invention has a cathode electrode 9 constituted by a backing plate 11 to which cooling water is introduced by a cooling water circulating mechanism, not shown, a permanent magnet 15 disposed on the back surface of the backing plate 11, and a target 18 fixed to the front surface of the backing plate 11. In front of this target 18, there are disposed an outer mask 7 and a substrate 10 supported by a substrate holder 3 rotatable about an axis. The mask 7 is fixed to and supported on the substrate holder 3 by a magnet, not shown.

At the centers of the backing plate 11 and the target 18, there is formed a through-hole 12 extending from the back surfaces to the front surfaces thereof, and a slide shaft 21 formed of an insulating material such as ceramics is inserted in the through-hole 12. The rear end portion of the slide shaft 21 is contained in a spring containing chamber 23 provided in the back surface of the backing plate 11, and is biased toward the fore end of the shaft by a spring 25 which is biasing means contained in the spring containing chamber 23.

The spring containing chamber 23 has a bottomed cylindrical shape having a flange portion 24 jutting out at an opening end, and is fixed to the back surface of the backing plate 11 at the flange portion 24. The vicinity of the rear end portion of the slide shaft 21 is supported for rotation about the axis thereof and translation in the direction of the axis thereof by a rotary ball spline 27 disposed in the spring containing chamber 23.

The surrounding wall constituting the spring containing chamber 23, the spring 25 and the rotary ball sprine 27 are designed to assume the same potential as the backing plate 11. An inner mask 4 should preferably assume the same potential as the substrate 10, or earth potential and therefore, the slide shaft 21 is partly formed of an insulating material to thereby achieve the electrical insulation between the inner mask 4 and the rotary ball spline 27 or the like.

The inner mask 4 is comprised of a mask portion 5 for actually covering the inner peripheral portion of the substrate as the inner mask, and a shaft portion 6 communicating with this mask portion. The shaft portion 6 is internally threaded on an end portion thereof differing from an end portion connected to the mask portion 5, and is threadably engaged with external thread formed on the distal end of the slide shaft 21, whereby it is made integral with the slide shaft 21 coaxially therewith. The mask portion 5 abuts against the central portion of the substrate 10, and covers a predetermined range of non-film formed area on the central portion of the substrate 10.

The mask portion 5 is biased toward the surface of the substrate by the spring 25. By making the biasing force of this spring 25 suitable, it becomes possible for the inner mask 4 to abut against the surface of the substrate 10 always with a constant and slight load. Also, by the inner mask 4 being rotatably supported through the slide shaft 21, the inner mask 4 becomes rotatable about the axis of the inner mask 4 together with the substrate 10. By this construction, it becomes possible to rotate the substrate about the axis actually during film forming and therefore, the distribution of the film thickness, etc. in the formed thin film is greatly improved.

Description will now be made of the procedure of actually effecting thin film forming on the substrate by the use of the sputtering apparatus according to the present embodiment. First, the substrate holder 3 receives the substrate 10 from a conveying apparatus with the outer mask 7 at a substrate receiving position. The holder 3 supporting the substrate 10 is driven to a position rightly opposed to the cathode electrode 9 by a holder driving mechanism, and approaches the cathode electrode 9 so that the interval between the surface of the substrate 10 and the surface of the cathode electrode 9 may assume a predetermined value. At this time, the mask portion 5 of the inner mask 4 abuts against a position corresponding to a non-film formed area on the inner peripheral side of the substrate. Also, a supporting member, not shown, for the cathode electrode and the holder driving mechanism are united to thereby form a vacuum vessel.

Subsequently, exhaust from the interior of the vacuum vessel is done by an exhaust system, not shown, and the pressure in the vacuum vessel is reduced to predetermined pressure, whereafter a gas for discharge such as argon is introduced into the vacuum vessel, and the pressure in the vacuum vessel is increased to discharge starting pressure by this gas. At the same time, rotation about the center of the substrate 10 held by the holder 3 is started. In this state, a predetermined voltage is applied to the cathode electrode 9, and the occurrence of discharge and the production of plasma are done between the target 18 and the substrate 10. The surface of the target is sputtered by ions produced in this plasma, and the sputtered particles adhere to and deposit on the substrate, whereby the forming of thin film is done.

The plasma is maintained for a predetermined time to thereby form thin film of a desired thickness, whereafter the application of the voltage to the cathode electrode 9 is stopped to thereby make the plasma disappear, thus terminating the forming of the thin film. Subsequently, a gas for purge such as dry nitrogen is introduced into the vacuum vessel to thereby make the pressure in the vacuum vessel equal to or higher than the atmospheric pressure, and the supporting member for the cathode electrode 9 and the holder driving mechanism are separated from each other. Subsequently, the substrate on which the film has been formed and the masks are removed from the retracted holder, and the film forming process is completed.

As described above, by the adoption of the construction according to the present invention, it becomes possible for the inner mask 4 to abut against the substrate 10 with a slight and constant load, and even if the substrate is rotated during film forming, the inner mask 4 and the substrate 10 do not mutually slide and therefore, it becomes possible to obtain good distribution of film thickness, etc. without injuring the substrate.

In the present embodiment, use is made of a substrate not formed with a through-hole centrally thereof and provided with a projection on the back side of the film formed surface thereof. The present invention, however, is not restricted thereto, but use may be made of a substrate having a through-hole in the central portion thereof. In that case, in order that during thin film forming, the inner mask 4 and the substrate holder 3 may assume the same potential, a spring or the like may be disposed on that surface of the central portion of the inner mask 4 which is adjacent to the surface of the substrate or that surface of the substrate holder 3 which is rightly opposed to the inner mask 4, and this spring may be used as the contact between the inner mask 4 and the substrate holder 3.

Also, while the slide shaft 21 is constructed as a single piece formed of an insulating material, the present invention is not restricted thereto, but the slide shaft 21 may be comprised of such a plurality of members as comprise an electrical conductor and an insulator connected together. Also, the method of connecting the slide shaft 21 and the inner mask 4 is not restricted to the threadable engagement by the mutual threaded structure, but it is possible to use one of various coupling methods. Also, as the backing plate 11, use is generally made of one formed of copper which is easy to work and is high in heat conductivity and can be easily water-cooled as a whole, but it is desirable that the wall of the spring containing chamber 23 be also formed of copper so that the rotary ball spline 27 can be cooled at the same time.

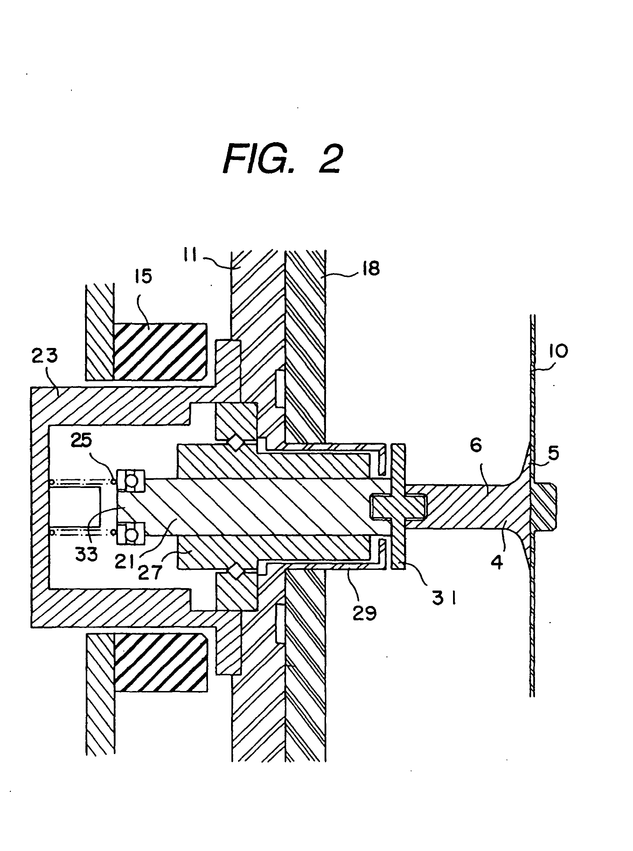

Fig. 2 shows an enlarged view of the essential portions of a sputtering apparatus which is a second embodiment of the present invention in a cross-sectional view thereof similar to Fig. 1. Constituents identical in action with the constituents shown in Fig. 1 are designated by the same reference numerals. In the construction of Fig. 1, the distance from the supported position of the slide shaft 21 to the position at which the mask portion 5 abuts against the substrate 10 is great and therefore, when the substrate 10 is rotated, shaft vibration may occur to the slide shaft 21 or the inner mask 4. Also, friction may occur in the portion of contact between the spring 25 and the end surface of the slide shaft 21 to thereby cause a load which hampers the inner mask 4 from following the rotation of the substrate 10 to rotate. The second embodiment copes with these problems.

Specifically, the rotary ball spline 27 is extended to the front surface of the target 18 and also, a thrust bearing 33 is disposed between the end portion of the slide shaft 21 and the end portion of the spring 25. In order to extend the rotary ball spline 27 toward the substrate, a containing chamber 29 protruding toward the substrate and capable of containing the rotary ball spline 27 is formed in the central portion of the backing plate 11. This containing portion 29 comprises a cylinder portion inserted in the through-hole 12 formed in the target 18 from the back surface toward the front surface thereof, and a lid portion disposed at the end portion of this cylinder portion which is toward the substrate and having a central aperture. The inner diameter of this central aperture is set slightly larger than the outer diameter of the slide shaft 21.

The slide shaft 21 slightly protrudes from the lid portion of the containing chamber toward the substrate side and has a length which always keeps the protruding state even if the slide shaft slides in the axial direction thereof by the spring 25, and is formed with an internally threaded portion on the end portion thereof toward the substrate. One of external threads on an insulating connecting plate 31 formed with externally threaded portions on the opposite surfaces thereof is threadably engaged with the internally threaded portion. The other external thread of the insulating connecting plate 31 is threadably engaged with an internally threaded portion formed on the shaft portion 6 of the inner mask 4, whereby the slide shaft 21, the insulating connecting plate 31 and the inner mask 4 are axially made integral with one another.

By this insulating connecting plate 31 being disposed, the outer wall of the containing chamber 29 can be prevented from being sputtered. Also, by the above-described construction, it becomes possible to support a portion near the center or that end portion of the slide shaft 21 which is toward the substrate by the rotary ball bearing 27, and it becomes possible to prevent shaft vibration from occurring to the slide shaft 21 and the inner mask 4 during the rotation of the substrate. Also, by the thrust bearing 33 being disposed between the rear end portion of the slide shaft 21 and the spring 25, the friction occurring between the end portion of the spring 25 and the slide shaft 21 is reduced and the rotation of the slide shaft 21, etc. about the axis thereof becomes smooth.

While in the present embodiment, the connection between the slide shaft 21 and the inner mask 4 is effected by the insulating connecting plate 31 formed of an insulating material, the present invention is not restricted thereto. Generally, when the inner mask 4 is to be brought to the same potential as the substrate holder 10 or earth potential by the utilization of an aperture portion provided centrally of the substrate, the connecting plate 31 may be made of a metal and may be endowed with a role as a so-called earth shield. Also, while the containing chamber 29 and the shaft portion 6 of the inner mask 4 are of a simple cylindrical shape, they may be of such a shape as partly constitutes, for example, a cone which becomes smaller in its diameter toward the substrate 10.

Also, while a construction in which the cathode electrode and the substrate are upright and rightly opposed to each other has been shown as the embodiment, the present invention is not restricted thereto, but they may be disposed so as to be horizontally opposed to each other. Also, while in the present embodiment, description has been made of a so-called magnetron sputtering apparatus in which a magnetic field by a permanent magnet is added, the present invention is not restricted thereto, but the present invention may be applied to a sputtering apparatus using no magnetic field, and may also be applied to a magnetron sputtering apparatus using an electromagnet or the like.

Also, while a sputtering apparatus has been mentioned as a thin film forming apparatus which becomes a subject when the present invention is used, the application of the present invention is not restricted thereto, but the present invention can be applied to various thin film forming apparatuses such as an evaporation-depositing apparatus and a CVD apparatus. Also, the present invention is not only used simply as a method of manufacturing an optical disk or the like, but also is applicable to a process of manufacturing products of which the step of removing the central portions is carried out later, for example, all of disk-shaped members such as hard disks.

By carrying out the present invention, it becomes possible for the inner mask to contact with the surface of the substrate always with a constant and slight load, irrespective of the kind of the substrate or the numbers of the laminated layers of the thin film. Also, film forming in a state in which the substrate and the inner mask are rotated as a unit becomes possible, and it becomes possible to achieve an improvement in the distribution of the film pressure, film nature, etc. of the thin film formed on the substrate.

## Claims

1. A sputtering apparatus for effecting film forming on a surface of a substrate having a substantially disk-like shape in a vacuum chamber, having:
a target comprising a main constituent element of film to be formed;
a backing plate for holding said target by a surface of said target;
a substrate holder for holding said substrate and rightly opposing the surface of said substrate to said target; and
an outer mask and an inner mask covering an outer peripheral portion and a central portion, respectively, of said substrate;
wherein said inner mask communicates with and is supported by a slide shaft extending through a through-hole formed in said target and supported by a bearing disposed on said backing plate for making rotation and translation possible, and abuts against the central portion of said substrate through said slide shaft with a predetermined load by biasing means disposed on said backing plate.

2. A sputtering apparatus according to Claim 1, wherein said biasing means comprises a spring disposed at an end portion differing from an end portion of said slide shaft which communicates with said inner mask.

3. A sputtering apparatus according to Claim 1, wherein said slide shaft has a portion formed of an insulating material in a portion thereof communicating with said inner mask.

4. A sputtering apparatus according to Claim 1, wherein said biasing means biases said slide shaft through a thrust bearing.

5. A sputtering apparatus according to Claim 1, wherein said backing plate protrude from a surface of said target and has a containing chamber formed with an aperture having an inner diameter slightly larger than a diameter of said slide shaft at a location rightly opposed to the center of said substrate, and the slide shaft protruding from said aperture toward said substrate, said bearing and said biasing means are contained in said containing chamber.

6. A thin film forming method of forming thin film on a substrate having a substantially disk-like shape, comprising:
disposing a target formed of a main constituent material of said thin film;
fixing said substrate onto a holder rightly opposed to said target and rotatable about a predetermined axis;
causing an inner mask connected to a shaft member extending from a back surface of said target to a front surface of said target through a through-hole formed in said target with said predetermined axis as the center to abut against a predetermined area of a central portion of said substrate;
causing plasma to occur between said substrate and said target;
sputtering the front surface of said target by ions in said plasma; and
depositing on a surface of said substrate thin film having a component of said target as a main constituent element;
wherein said inner mask abuts against said substrate with a predetermined load, and when the depositing of said thin film is effected, said inner mask is rotated about said predetermined axis together with said substrate.

7. A disk-shaped recording medium manufacturing method of forming particular film on a disk-shaped recording medium, comprising:
disposing a target formed of a main constituent material of said particular film;
fixing a substantially disk-shaped substrate onto a holder rightly opposed to said target and rotatable about a predetermined axis;
causing an inner mask connected to a shaft member extending from a back surface of said target to a front surface of said target through a through-hole formed in said target with said predetermined axis as the center to abut against a predetermined area of a central portion of said substrate;
causing plasma to occur between said substrate and said target;
sputtering the front surface of said target by ions in said plasma; and
depositing said particular film on a surface of said substrate;
wherein said inner mask abuts against said substrate with a predetermined load, and when the depositing of said particular film is effected, said inner mask is rotated about said predetermined axis together with said substrate.
